# EUROPÄISCHE PATENTANMELDUNG

(11) **EP 0 649 226 A2**
(43) Veröffentlichungstag der Anmeldung: **19.04.1995**
(21) Anmeldenummer: 94111289.8
(22) Anmeldetag: 20.07.1994
(51) Int. Cl.: H04B 1/30

(54) **Schaltungsanordnung für Funkrundsteuerempfänger im Langwellenfrequenzbereich**

(30) Priorität: 13.10.1993 DE 4335658
(71) Anmelder: DeTeWe FUNKWERK KOPENICK GmbH, D-12557 Berlin (DE)
(72) Erfinder: Drescher, Jürgen, D-12557 Berlin (DE)

(57) **Zusammenfassung**

Eine Schaltungsanordnung für Funkrundsteuerempfänger im Langwellenfrequenzbereich zum Empfangen von frequenzmodulierten Rundsteuersignalen, weist als Empfangsantenne (1) zwei gleiche, elektromagnetisch abgeschirmte Spulen auf einem gemeinsamen Ferritstab auf. Die Spulen sind mit zwei gleich gebauten Tiefpässen (2, 3) verbunden, die ausgangsseitig an einen Differenzverstärker (4) geschaltet sind. Dem Differenzverstärker (4) sind eine Mischstufe (5) und Selektionsmittel (6) nachgeordnet.Letztere sind über einen regelbaren Verstärker (7) an einen Frequenzhub-Vervielfacher (8) geschaltet. Dem Frequenzhub-Vervielfacher (8) ist ein Demudolator (9) nachgeschaltet, der aus einer Frequenzmodulation eine Phasenmodulation erzeugt und diese demoduliert.

## Beschreibung

Die Erfindung betrifft eine Schaltungsanordnung für Funkrundsteuerempfänger im Langwellenfrequenzbereich zum Empfangen von frequenzmodulierten Rundsteuersignalen.

Der Langwellenfrequenzbereich ist geeignet für eine großflächige Funkrundsteuerung, da die Bodenwelle zuverlässig in Entfernungen von bis zu 500 Kilometern empfangen werden kann. Nachteilig im Langwellen-Frequenzbereich sind die industriell bedingten Störfeldstärken.

Um die Beeinflussung durch Störfelder gering zu halten wurde vorgeschlagen, die Senderstandorte entsprechend auszusuchen und geeignete Nutzfeldstärken zu wählen.

Außerdem ist bekannt, durch die Verwendung einer Schmalband-Frequenzmodulation den Einfluß von Störfeldstärken zu verringern.

Der Erfindung lag die Aufgabe zugrunde, einen Funkrundsteuerempfäger für den Langwellen-Frequenzbereich unter Anwendung eines Schmalband-Frequenz-Modulations-Verfahrens zu schaffen, dessen Beeinflussung durch Störfelder gering ist.

Diese Aufgabe ist durch die Gesamtheit der Merkmale des ersten Patentanspruches gelöst. Weitere vorteilhafte Maßnahmen sind Gegenstand der Unteransprüche.

Die Erfindung basiert auf Verwendung wirtschaftlicher Schaltkreise, sogenannter "Pager"-Schaltkreise, die ein relativ einfaches Umsetzen der Empfangsfrequenz in ein niederfrequentes Band gestatten. Dabei wird aus der zur Signalübertragung verwendeten Frequenzmodulation durch Mischung des Nutzsignals in das Basisband des Empfängers eine Phasenmodulation mit großem Phasenhub erzeugt, die anschließend in einem Phasen-Demodulator demoduliert wird

Die Erfindung wird anhand eines Blockschaltbildes nachfolgend näher erläutert.

Als Empfangsantenne 1 des Funkrundsteuerempfängers dienen zwei gleiche Spulen auf einem Ferritstab. Diese elektromagnetisch abgeschirmten Spulen sind mit den Eingängen von zwei gleich aufgebauten Tiefpässe 2, 3 verbunden. Die Tiefpässe 2, 3 dienen als Zwischenfreqenz- und Spiegelfrequenz-Sperrfilter. Die Ausgänge der Tiefpässe 2, 3 sind über einen Differenzverstärker 4 an eine Mischstufe 5 geschaltet. In der Mischstufe 5 wird die Nutzsignal-Frequenz mit einer geeigneten Frequenz überlagert. Zu diesem Zweck ist ein Oszillator OSZ an den zweiten Eingang der Mischstufe 5 gelegt. Über eine Selektionsstufe 6 gelangen die Signale an einen regelbaren Verstärker 7. Der regelbare Verstärker 7 hat die Aufgabe, abhängig vom Nutzsignal-Empfangspegel einen konstanten Pegel für den nachgeschalteten Frequenzhub-Vervielfacher 8 zu erzeugen. Der Frequenzhub-Vervielfacher 8 ist als Minimumbegrenzer ausgelegt. Dies bedeutet, daß Störpegel, die einen bestimmten Wert nicht überschreiten, im weiteren Signalweg nicht übertragen werden. Der Faktor der Vervielfachung des Nutzsignal-Freqenzhubes ist dabei abhängig von den Eigenschaften der verwendeten Schaltkreise.

Im nachgeschalteten Demodulator 9 wird das freqenzmoduliert übertragene Nutzsignal in ein phasenmoduliertes Signal mit großem Phasenhub umgesetzt und demoduliert.

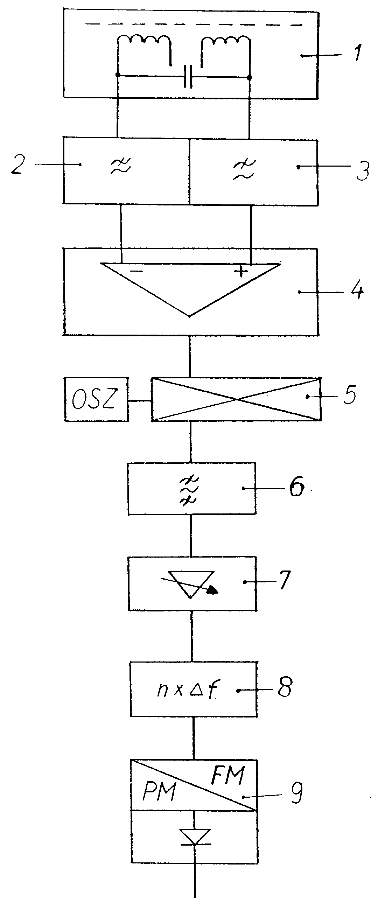

## Patentansprüche

1. Schaltungsanordnung für Funkrundsteuerempfänger im Langwellenfrequenzbereich zum Empfangen von frequenzmodulierten Rundsteuersignalen, dadurch gekennzeichnet,
daß als Empfangsantenne (1) zwei gleiche, elektromagnetisch abgeschirmte Spulen auf einem gemeinsamen Ferritstab dienen und die Spulen mit zwei gleich gebauten Tiefpässen (2, 3) verbunden sind,
daß die Tiefpässe (2, 3) ausgangsseitig an einen Differenzverstärker (4) geschaltet sind,
daß dem Differenzverstärker (4) eine Mischstufe (5) und Selektionsmittel (6) nachgeordnet sind, die über einen regelbaren Verstärker (7) an einen Frequenzhub-Vervielfacher (8) geschaltet sind und
daß dem Frequenzhub-Vervielfacher (8) ein Demudolator (9) nachgeschaltet ist, der aus einer Frequenzmodulation eine Phasenmodulation erzeugt und diese demoduliert.

2. Schaltungsanordnung nach Anspruch 1, dadurch gekennzeichnet, daß an einen Eingang der Mischstufe (5) ein Oszillator (OSZ) geschaltet ist.

3. Schaltungsanordnung nach Anspruch 1, dadurch gekennzeichnet, daß der Frequenzhub-Vervielfacher (8) als Minimumbegrenzer ausgelegt ist.
